# EUROPEAN PATENT APPLICATION

(11) **EP 4 679 286 A1**
(43) Date of publication of application: **14.01.2026**
(21) Application number: 24188021.0
(22) Date of filing: 11.07.2024
(51) Int. Cl.: G06F 16/332, G06F 16/338, G06F 16/2458

(54) **METHOD FOR OBTAINING A SEARCH RESULT FOR A SEARCH QUERY WITHIN A DATABASE SYSTEM OF A PLANT**

(71) Applicant: ABB SCHWEIZ AG, 5400 Baden (CH)
(72) Inventor: TAN, Ruomu, 68309 Mannheim (DE); SCHOCH, Nicolai, 69120 Heidelberg (DE); SHARMA, Divyasheel, 560048 Bangalore, Karnataka (IN); BORRISON, Reuben, 68782 Brühl (DE)
(74) Representative: Maiwald GmbH

(57) **Abstract**

The disclosure relates to a method (100) for obtaining a search result for a search query within a database system (12) of a plant, the database system (13) storing multimodal operating data of the plant, the method (100) comprising:
- obtaining the search query indicative of an operating characteristic in the operating of the plant to be searched within the database system (13);
- executing the search query by an artificial intelligence / machine learning, Al / ML, search component (12) within the database system (13) for finding the searched operating characteristic and time intervals of the operating characteristic among different data modalities of the multimodal data therein; and
- obtaining a search result indicative of the operating characteristic and its time intervals found by the execution of the search query by the Al / ML search component (12).

## Description

### TECHNICAL FIELD

The present invention relates to a method for obtaining a search result for a search query within a database system of a plant, a computer program product, and a data processing system.

### BACKGROUND

Today, plant operators can use keyword or semantic search for data/situations in a database of a plant, in particular industrial plant, e.g., by using standard keyword search methods. However, this does not provide any multimodal aspects, as multimodal data often is not directly searchable or cannot simply be brought into context with a "search term".

However, it would be desirable to be able to conduct multimodal searches in databases of a plant, i.e., simultaneously on multimodal data, e.g., for time periods with characteristics that can be specified by natural language inputs.

In particular, when analyzing the plant history by searching the database of the plant, it may be challenging to search for time periods with interesting events because the signatures of the events may exist in various types of historical plant data and may take various forms. Currently the plant operator who is analyzing the plant history can only run partial search, e.g., in time series data. They may need to manually search in other types of data, such as maintenance logs, and manually cross-check the information from various sources in order to determine which time intervals are of interest. This type of search requires both intensive manual efforts and a reasonable level of domain know-how.

### SUMMARY

The above problem is at least partially solved or alleviated by the subject matters of the independent claims of the present disclosure, wherein further examples are incorporated in the dependent claims.

According to an aspect of the present disclosure, there is provided a method for obtaining a search result for a search query within a database system of a plant, in particular an industrial plant, the database system storing multimodal operating data of the plant, the method comprising:
- obtaining the search query indicative of an operating characteristic in the operating of the plant to be searched within the database system;
- executing the search query by an artificial intelligence / machine learning, Al / ML, search component within the database system for finding the searched operating characteristic and time intervals of the operating characteristic among different data modalities of the multimodal data therein; and
- obtaining a search result indicative of the operating characteristic and its time intervals found by the execution of the search query by the Al / ML search component.

Hence, the method provides for a multimodal plant data search, where a user or plant operator can perform complex plant data searches in a natural and intuitive way. The multimodal search results are more holistic and provide a comprehensive understanding of the plant situation compared to a keyword-based search. For example, when searching for anomalies like a current multivariate process behavior, the plant operator could not only get the similar time intervals from the process data in the database system but also a contextually summarized related note from shift and maintenance logs and/or service tuning reports of the plant. Such a comprehensive search approach can make it easier for the users such as the plant operators to digest the search results better and faster and make optimal plant operation decisions.

Specifically, by using an artificial intelligence / machine learning, AI / ML search component, a search query obtained based on a user or plant operator input at a computer, a database system of the plant may be searched to find a searched operation characteristic as defined by the search query received from the plant operator. Particularly, the operating characteristic or characteristics indicated by the search query may not be found as such but with their time intervals, meaning the times at which the operation characteristics have been recorded or stored in the database system. This allows to understand the operation of the plant for one or more operating characteristics as defined by the plant operator based on the search query over time. The AI / ML search component may be implemented in software and/or hardware. The AI / ML search component may be pretrained and/or continuously trained for executing the search query based on training data, which may include previous or current search queries and/or search results. Generally, the AI / ML search component may be based on neural networks, deep learning techniques and similar, to improve the search results with every search query or every few executed search queries. Specifically, the AI / ML model may have the search query as input and the search result as output.

Generally, the database system of the plant may store operating data accumulated or recorded during the operation of the plant. For example, such operating data may be obtained by the database system on one or more systems of the plant, e.g., a logging system for logging certain actions such as events, alarms, or maintenance, and/or one or more technical equipment of the plant, e.g., sensors, actuators, and so on. Accordingly, such operating data may be indicative of the operation of the plant at a given time. The operating data may be stored with time stamps indicating the time that the operating data was recorded by the respective system or technical equipment and/or it was stored in the database system. Hence, it may be possible to find out, when finding the relevant entries of operating data in the database system, when these were recorded and/or stored. For example, a plant operator may want to know when the plant experienced a certain temperature of a technical equipment as may have been recorded by one or more temperature sensors. The database system may have stored these recordings as operating data and the plant operator may be able to access the operating data when finding it by using a search query for the type of operating data, e.g., temperature readings, and a specified time for which they want to have the operating data. However, for some systems and technical equipment, the operating data may not only or not at all be stored as searchable text but rather as multimodal data, e.g., including video, images, and similar. In these cases, it may be very difficult to find that type of operating data or find all relevant operating data with a keyword search. However, executing the search query by the AI / ML search component, in particular which was trained with search queries and search results as input and output on that very database system and/or other, e.g., similar, database systems of plants, it may be possible to find the operating data with its time intervals among different data modalities of multimodal data in the database system, which would otherwise not be accessible through keyword search and require a lot of manual search. Specifically, the AI / ML search component may be able to search multimodal data in a different way than a keyword search by employing different techniques for different data modalities such as video, images and log data, similar to a human plant operator, who, based on their knowledge, may screen different data modalities without a keyword search knowing what they are looking for.

The database system itself is associated with the plant such that it stores its operating data. Generally, the database system does not have to be provided on a single computer or data processing apparatus but may be provided on a data processing system, which may have several data processing apparatuses, including cloud computers, among which the database system may be distributed. For example, different types of operating data or operating data from different systems or technical equipment may be stored among different data processing apparatuses or computers. Alternatively, the operating data may be stored on a central database system of a data processing apparatus to accumulate all operating data.

The method may in particular be a computer-implemented method. Accordingly, one, multiple or all steps of the method may be carried out by a data processing system, which may comprise one or more computers or, in other words, data processing apparatuses.

In particular, the AI / ML search component may be a generative machine learning model. In an example, the AI / ML search component model may be a generative AI / ML search component based on at least a Large Language Model, LLM, and/or a multimodal model. The generative AI / ML search component may be implemented in or provided as software and executed on the same data processing system as the one which may be executing the step of obtaining the search query, for example. For example, the AI / ML search component may be executed on distant or remote servers, which may have increased data processing capabilities and storages for storing one or more LLMs. Alternatively, these may be locally stored and executed. The generative AI / ML search component may be based on a trained model with or based on any LLM, e.g., general LLM and/or LLM specific for executing search queries. In particular, the AI / ML search component may be based on at least one multimodal model and/or be configured to process multimodal data, such as but not limited to video and/or image data such as screen recording data, camera data, audio data, log data, text data and similar. Specifically, the multimodality may relate to or include audio data, log data, image data and/or video data in addition to text data. Consequently, the AI / ML search component may process the search query among the different data modalities of the multimodal data in the database system, enabling it to find search results indicative of one or more operating characteristics and their time intervals which are included in a data modality different from text and/or different data modalities.

In an example, the database system may contain data representations of the multimodal operating data in a joint embedding space. Specifically, to optimize the multimodal search by the AI / ML search component, the multimodal operating data may be structured in the database system. For this structuring, the database system may contain the data representations, in particular embedding data representations, of the multimodal operating data in the joint embedding space in the database system. For example, the multimodal operating data may be embedded into embedding data representations using one or more transformer models, e.g., using a tokenizer for text and time series data as data modalities, an autoencoder for image data as data modality, and/or similar. The embedding data representations may refer to and/or comprise the multimodal operating data in the embedded form as provided by the one or more transformer models, for example. In particular, the embedding data representations may be in the form of abstract embedding representations of the different data points of the multimodal operating data. The joint embedding space may be configured as or comprise a high-dimensional index, which may maintain relationships between the multimodal operating data, e.g., between process variables and technical equipment of the plant, e.g., static operating data of a topology of the plant and dynamic operating data of a current process state of the plant.

In an example, the data representations of the multimodal operating data may be contextually linked with one another by an information model and/or a knowledge graph. In other words, the data points of the operating data represented by the data representations may be brought into context by means of an underlying information model and/or knowledge graph. From the information model and/or knowledge graph, different information may be derived, e.g., that a high or increasing temperature in a technical equipment of the plant has an effect on high or increasing pressure, for example. For example, the joint embedding space may be structured such that it contains or captures the information in the plant operating data along with the relationships between the operating data. One example to realize this is to create a graphical representation, e.g., in the form of a knowledge graph. This graphical representation may use a standard plant ontology or can be derived and/or learned from the operating data. In this graphical representation, the operating variables and technical equipment of the plant may be represented by nodes of the graph. The technical equipment might be already known from requirements (such as control narratives, IO lists etc.) or can be extracted from a plant topology diagram (such as a piping and instrumentation diagram). For node attributes in the graphical representation, respective operating data, in particular process, alarm & event data, may be referenced with each process variable of the plant. Moreover, maintenance events that are extracted from the maintenance logs may be associated with the plant equipment. Further, in the graphical representation, the edges may comprise technical equipment connected to each other based on the plant topology, and/or the process variables connected to technical equipment, e.g., based on measurement device's association with the technical equipment, the measurement devices measuring the process variables. Once an initial knowledge graph representation is available, it may be update with plant context, i.e., the dynamic state of the plant that is derived from the process data. One way to realize this is by using an attention-based mechanism to learn a graph attention network, GAT. In particular, for the process of embedding the data representations of the multimodal operating data in the joint embedding space, a further AI / ML component, specifically an AI / ML embedding component, may be used. For example, given an initial graph, random embedding vectors for the graph nodes may be used, and then learn a cross-modal matcher (optionally, this could be pre-trained LMM, which is capable of multimodal search, i.e., LLM integrated with some models that understand non-language modes) or a joint embedding in a shared representational space. Specifically, the thus obtained data points (or their abstract embedding representations) may be brought into context by means of a secured underlying information model or knowledge graph, from which, e.g., it can additionally be derived, that, e.g., high/increasing temperature has an effect on high/increasing pressure as exemplary described above. For instance, a plant operator might query "I am looking for time intervals with excessively high temperature". Given the search query, the AI / ML search component may be used to interpret the search query for execution thereof. The interpretation of the query might be dependent on the data source. For example, if the graph is stored as an embedding in a vectorized index, then the search query may also be mapped to the same space embedding, and a search result may be retrieved. However, alternatively, if the graph is stored as a graph database with a query language, then an LLM may translate the natural language query to the query language construct that can then run on the "temperature" variable and find time intervals above an inferred pre-set temperature threshold from the graph database.

In an example, the operating characteristic may be an operating parameter of the plant and/or an operating problem of the plant. Accordingly, the search query may indicate an operating parameter of the operating process of the plant and/or an operating problem in the operating process of the plant, e.g., for troubleshooting. Also, there may be multiple operating characteristics indicated by the search query and searched for by the AI / ML search component.

In an example, the search query may comprise natural language text, a function, a time series of values, and/or an image indicative of the operating characteristic. Hence, the search query itself may also include multimodal data indicative of or defining the operating characteristic or characteristics that are searched in the operating data stored in the database system. The AI / ML search component may be configured to handle such search query based on multimodal data similarly to the multimodal operating data to be searched.

In an example, the multimodal operating data in the database system may be at least from one or more of: time series data, text data, log data, and/or image data. Also, video data, audio data, and other types of data may be additionally or alternatively included in the afore-mentioned list, from which the multimodal operating data may be. The AI / ML search component may be trained and/or use techniques for conducting the search in each one of these data types of that list, which may also be referred to as data modalities in the present disclosure.

In an example, the multimodal operating data in the database system may store one or more of: process variables data, process topology data, analytical model data, operating manual data, event log data, alarm log data, and/or maintenance log data. For example, the process variables data may contain a number or list of tag names relating to the searched operating characteristic. For example, when the operating characteristic is a temperature, e.g., a predefined maximum or minimum temperature, in particular an excessively high temperature, then the process variables data may contain a list of tag names that are at least temperature measurements indicating the excessively high temperature. For this purpose, for example, the search query may be typed in text or be obtained in the form of text data containing e.g. "I am looking for time intervals with excessively high temperature in the plant". Further, for example, time series data as data modality may generally comprise time intervals and associated operating characteristics, e.g., temperature variables such that these temperature variables were higher statistically or showed a certain trend in these time intervals. Analytical model data may for example comprise time intervals have been detected by a model, such as a multivariate machine learning model, as potential anomalies and corresponding operating characteristic, e.g., excessively high temperature, variables that contributed to most of the anomaly. Alarm and/or event log data may indicate time intervals of an alarm or event in relation to the operating characteristic, e.g., the excessively high temperature. The process topology data may for example comprise the names of the technical equipment of the plant with their searched operating characteristic variables, e.g., temperature variables that were excessively high for the found time periods. Further, the maintenance log data may comprise maintenance logs where a plant operator noted maintenance efforts on the found technical equipment and/or for the operating characteristic, e.g., against high temperature on certain issues. In any case, the AI / ML search component may search through any one or more of these data types to deliver a very accurate and at least nearly complete search result for the obtained search query. Additional multimodal operating data may be derived in case an information model or knowledge graph is used, e.g., that the concept "temperature" is linked via a relation, e.g., "has_influence_on" to another concept, e.g., "pressure". Maybe it is even represented that "higher temperature" or "temperature increase" is related proportionally to "higher pressure" or "pressure increase". Hence, the above- search process and search result can also be performed for "pressure" or high pressure, in this exemplary case by involving or using the information model that may have been created. The knowledge propagation through the information model or knowledge graph does not end after one concept-to-concept relation, but it can propagate to the respectively next concept(s), too. Here, a threshold may make sense, to, e.g., only show next-next-...-concepts if and only if the direct or direct-next concepts has not brought any further insights from multimodal search.

In an example, the search result may be configured as a visualization of the found operating characteristic or characteristics over a timeline including the time intervals. Thereby, the evolution of the searched operating characteristic or characteristics may be visually provided to the plant operator, who may quickly analyze them, e.g., for any issue of the plant or similar such as in the exemplary case of excessively high temperature.

In an example, the method may further comprise determining a state of the plant for one of the time intervals indicated by the search result, the state being indicative of several operating characteristics of the plant based on the multimodal operating data of the database system. For example, the plant operator may provide user input obtained by the method, the user input being indicative of the requested state of the plant for one of the time intervals. For example, the plant operator may be able to select a time interval on the timeline of the visualization of the found operating characteristic. Then, the state of the plant may be determined or visualized including several other operating characteristics to give a broader picture of the state of the plant during the time interval.

Specifically, in an example, the method may further comprise navigating through the determined state of the plant along a timeline including the time interval on a user interface of a data processing system, the several operating characteristics of the state changing while navigating the timeline based on the multimodal operating data of the database system. The navigating may be achieved based on user input on the user interface of the data processing system. For example, the user interface may be any input means such as a keyboard, mouse, controller, and similar. Hence, based on user input obtained by the method at the user input, the method may be navigating through the determined state of the plant along the timeline. Here, the operating characteristics will be changing along the timeline such that the state or operation of the plant is replayed, e.g., with the sequence of performed actions.

In an example, the method may further comprise utilizing the search result for analyzing, planning and/or simulating an operation of the plant. For example, the search result may be analysed for potential issues or problems in the operation of the plant. Also, the search result may be used to plan certain operations, e.g., when to perform them such that the excessively high temperatures do not occur or similar. Also, a simulation of the operation of the plant may benefit from the search result as it may be used directly or indirectly for the simulation.

In an example, the search query is received on a user interface of a data processing system and the search result is provided on the user interface. For example, the user interface may comprise the input means as described and/or output means, such as one or more monitors, for example, to visually output the search result.

According to a second aspect of this disclosure, there is provided one or more computer program products comprising instructions which, when executed by a data processing system, causes the data processing system to carry out the method of the first aspect of this disclosure.

The computer program product or products may be one or more computer programs as such, meaning a computer program or programs consisting of or comprising program code to be executed by the data processing system, in particular one or more computers.

Alternatively, the computer program product or products may be a product or products such as one or more data storages, in particular computer-readable data storage mediums, on which the computer program or programs may be temporarily or permanently stored.

According to a third aspect of this disclosure, there is provided a data processing system configured to carry out the method according to the first aspect of this disclosure. For this purpose, the data processing system may comprise a computer or data processing apparatus and/or the one or more computer program products of the second aspect of this disclosure, for example.

It is noted that the above aspects, examples and features may be combined with each other irrespective of the aspect involved.

The above and other aspects of the present disclosure will become apparent from and elucidated with reference to the examples described hereinafter.

### BRIEF DESCRIPTION OF THE DRAWINGS

Exemplary embodiments will be further described with reference to Figures, wherein:
Figure 1 shows a method for obtaining a search result for a search query within a database system of a plant;
Figure 2 shows a data processing system of the plant, by means of which the method of Fig. 1 may be executed; and
Figure 3 shows a visualization of the search result of Fig. 1 on a user interface of the data processing system of Fig. 2.

The Figures are schematic only and not true to scale. In principle, identical or like parts, elements and/or steps are provided with identical or like reference numerals in the Figures.

### DETAILED DESCRIPTION OF THE INVENTION

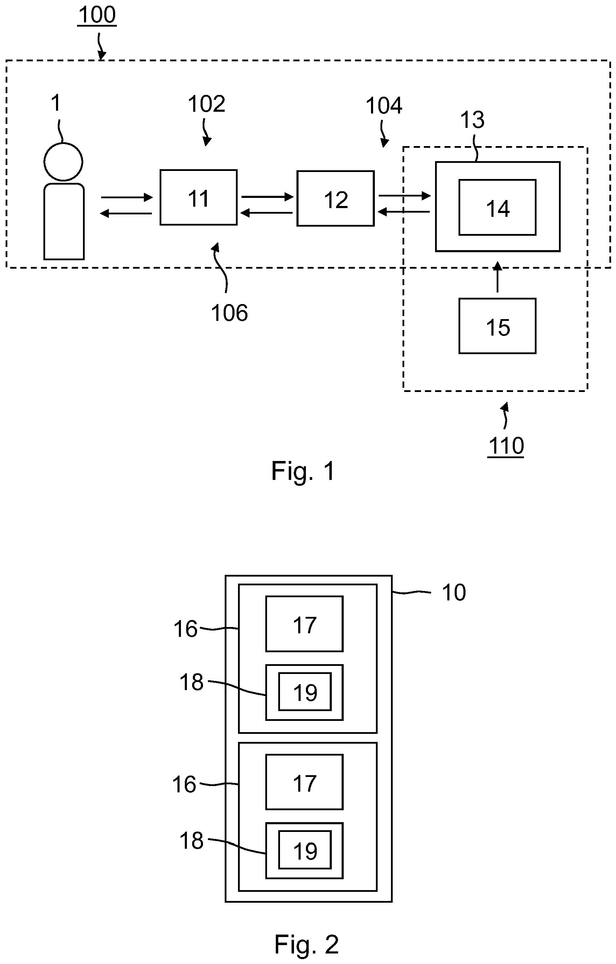

Fig. 1 shows a schematic illustration of a method 100 for obtaining a search result for a search query within a database system 13 of a plant, in particular industrial plant. For example, such plant may be a processing and/or manufacturing plant. Examples of such a plant are chemical plants, power plants, oil and gas plants, and so on. These types of industrial plants may carry out industrial processes, e.g., to manufacture a chemical, oil, gas or generate power, for example. For these purposes, the plant may have several technical equipment and systems for controlling the technical equipment or industrial processes.

Typically, operating information about the plant operation or operating processes of the plant are being stored in a database system 13 of the plant as shown in Fig. 1. Thereby, when a plant operator such as the shown user 1 in Fig. 1 wants to access operating data from previous operations of the plant, in particular previous time intervals, the user 1 may access the database system 13 through a user interface 11, which may be comprising any user input and/or output means, such as a mouse, keyboard, monitor, and so on. Specifically, the user 1 may typically type keywords into a search engine or platform to have the operating data stored in the database system 13 searched. However, a keyword search is limited in terms of capabilities as it typically only searches text data and no multimodal data. Also, only keywords and no relationships or questions may be searched or asked for the search engine or platform to deliver results.

To improve this, the method 100 of Fig. 1 and data processing system 10 of Fig. 2 are suggested. As shown in Fig. 2, the data processing system 10 may comprise one or more data processing apparatuses 16 or computers. In the example of Fig. 2, two data processing apparatuses 16 are exemplary shown. In this example, each one of these has their own processing unit 17, e.g., a CPU. Also, in this example, each one of these has their own computer program product 18 in the form of a storage medium, which may be comprising a computer program 19 or software instructions which, when executed by the respective processing unit 17, carry out the method 100 of Fig. 1.

Further, as shown in Fig. 1, any one of the components 11, 12, 13, 14 and 15 in Fig. 1 may be part of the data processing system 10. For example, the user interface 11 may be part of or connected to any one of the data processing apparatuses 16. Also, the database system 13 may be part of the data processing system 10, e.g., provided on one of the computer program products 18 in the form of storage mediums or distributed among them or provided on a separate storage medium for a centralized database system 13, for example. Component 12 is an AI / ML search component, which may be implemented in software on any one of the computer program products 18 or separately therefrom in another storage medium, e.g., of a cloud data processing apparatus of the data processing system 10. Similarly, component 12 is an AL / ML embedding component, which may also be implemented in software on any one of the computer program products 18 or separately therefrom in another storage medium, e.g., of a cloud data processing apparatus of the data processing system 10.

To obtain a search result for a search query within the database system 13 of the plant, the method 100 comprises, in a first step 102, obtaining the search query indicative of an operating characteristic in the operating or, in other words, operation process of the plant, wherein the operating characteristic is to be searched within the database system. Of course, the search query may be also indicative of multiple operating characteristics to be searched. The search query may be obtained at or by the data processing system 10, specifically via the user interface 11. For this purpose, the user 1 may provide the search query as user input on the user interface 11, e.g., in the form of a text. For example, the search query may be provided as a prompt. However, the search query is not limited to text, specifically natural language text, but can also or alternatively include any one of a function, a time series of values (operating or process values of the plant or its process) or an image, which may be indicative of the operating characteristic to be searched.

The search query is specifically obtained at or further provided to the AI / ML search component 12. In a second step 104 of the method 100 as exemplary illustrated herein, the search query, e.g., in the form of a prompt, is executed by the AI / ML search component 12 within the database system 13 for finding the search operating characteristic together with their time intervals of occurrence, e.g., the measurement of measurement values as operating characteristic, and/or storage in the database system 13. In particular, the second step 104 may be executed on or by the data processing system 10.

Specifically, the database system 13 contains multimodal data comprising the operating characteristic to be searched / found among other operating characteristic and generally operating data stored in conjunction with the operation of the plant. The multimodal data comprises different data modalities such as but not limited to time series data, text data, log data, and/or image data. And the AI / ML search component is a generative AI / ML search component based on at least a multimodal LLM. Thereby, it may query or search the database system 13 in a way, which enables it to generate a search result for the search query independent of the data modalities in which the information for the operating characteristic is being stored in the database system 13, enabling it to find more results than with a keyword search. Also, being an AI / ML search component 12, not just keywords but entire prompts or requests may be given to the AI / ML search component 12.

An exemplary search query in a plant with text may be "I am looking for time intervals with excessively high temperatures (in the plant operation)". Such search query may be accompanied by data in another data modality, e.g., an image showing a temperature variable trend and the search query may be extended to for example "I am looking for time intervals with excessively high temperatures similar to as indicated in the provided variable trend." Additional requests such as "Create a timeline and historical evidence from different types of related operating data" may also be included in the search query as prompt for the AI / ML search component 12.

Generally, the AI / ML search component 12 may have been pre-trained based on the multimodal LLM and/or trained with search queries and/or search results as input on the fly or continuously after deployment in the data processing system 10.

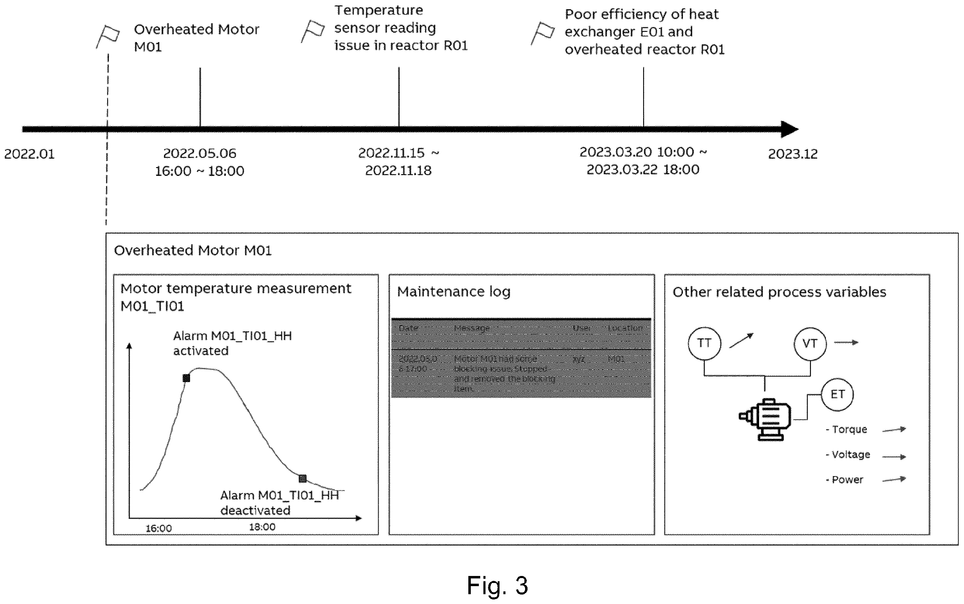

Then, in a third step 106 of method 100, on or by the data processing system 10, the search result indicative of the operating characteristic and its time intervals found by the execution of the search query in the second step 104 is obtained. Consequently, the search result may be output to the user 1 on the user interface 11, for example. The output for the example of the search query as described above is illustrated in Fig. 3 as a visualization of the found operating characteristic (of the excessively high temperature) over a timeline including the time intervals and will be described further below.

To further improve the search in the database system 13, the database system 13 may contain data representations of the multimodal operating data in a joint embedding space 14. There, the multimodal operating data of the plant may be contextually linked with one another by an information model and/or a knowledge graph. For this purpose, in a separate method 110, which however may be part of the method 100 as one or more steps thereof, the embedding may be executed on the multimodal operating data using different transformer models as described herein depending on the data modality, which is embedded, for example. Specifically, the information model and/or knowledge graph may be generated. For this purpose, a further AI / ML embedding component 15 may be used, which may have been pre-trained and/or trained on the fly or during operating. The further AI / ML embedding component 15 may in particular continuously embed new operating data in the joint embedding space 14. Accessing the joint embedding space 14 with the contextual links of the different operating data facilitates the execution of the search query by the AI / ML search component 12.

Fig. 3 shows the visualization of the search result for the above example of the excessively high temperature as obtained by the AI / ML search component 12. Exemplary, three different instances of the excessively high temperature as operating characteristic were found in this case between the time of 2022.01 to 2023.12, which may have been defined by the search query as time to be searched. Exemplary, the three instances are of an overheated motor as technical equipment in the plant, of a temperature sensor reading issue in a reactor as technical equipment, specifically measurement device, and of a poor efficiency of heat exchanger and overheated reactor as technical equipment in the plant, which are given over a timeline as visualization. Specifically, the found operating characteristic of the excessively high temperature is thereby given over a timeline including the time intervals.

Moreover, in Fig. 3, a state of the plant for one of the time intervals indicated by the search result, here the one for the instance of the overheated motor, is given in the visualization. This state is further indicative of several other operating characteristics of the plant based on the multimodal operating data of the database system 13, which are referenced in Fig. 3 as "other related process variables". Further, as seen in Fig. 3, the excessively high temperature for the first instance of overheated monitor is based on different data modalities, namely time series data or image data for the motor temperature measurement and text data for the maintenance log data as operating data. The different data modalities are visualized in the visualization with their operating data, specifically in so far as it is relevant as search result for the search query.

In the visualization of Fig. 3, the user 1 may, by providing user input, navigate through the determined state of the plant along the timeline on the user interface 11, the several operating characteristics of the state changing while navigating the timeline based on the multimodal operating data of the database system 13. For example, the user 1 may scroll through the timeline, thereby changing the operating characteristics that are showed and replaying the operating process of the plant.

While the invention has been illustrated and described in detail in the drawings and foregoing description, such illustration and description are to be considered illustrative or exemplary and not restrictive. The invention is not limited to the disclosed embodiments. Other variations to the disclosed embodiments can be understood and effected by those skilled in the art and practicing the claimed invention, from a study of the drawings, the disclosure, and the claims.

As used herein, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Further, as used herein, the phrase "at least one" or similar, e.g., "one or more of", in reference to a list of one or more entities should be understood to mean at least one entity selected from any one or more of the entities in the list of entities, but not necessarily including at least one of each and every entity specifically listed within the list of entities and not excluding any combinations of entities in the list of entities. This definition also allows that such entities may optionally be present other than the entities specifically identified within the list of entities to which the phrase "at least one" or similar refers, whether related or unrelated to those entities specifically identified. Thus, as a non-limiting example, "at least one of A and B" (or, equivalently, "at least one of A or B" or, equivalently "at least one of A and/or B" or, equivalently "one or more of A and B", "one or more of A or B", or "one or more of A and/or B") may refer, in one example, to at least one, optionally including more than one, A, with no B present (and optionally including entities other than B); in another example, to at least one, optionally including more than one, B, with no A present (and optionally including entities other than A); in yet another example, to at least one, optionally including more than one, A, and at least one, optionally including more than one, B (and optionally including other entities). In other words, the phrases "at least one," "one or more," and "and/or" are open-ended expressions that are both conjunctive and disjunctive in operation. For example, each of the expressions "at least one of A, B, and C," "at least one of A, B, or C," "one or more of A, B, and C," "one or more of A, B, or C," and "A, B, and/or C" may mean A alone, B alone, C alone, A and B together, A and C together, B and C together, A, B, and C together, and optionally any of the above in combination with at least one other entity.

As used herein, the phrase "being indicative of" may for example mean "reflecting" and/or "comprising". Accordingly, an entity, element and/or step referred to herein as "being indicative of [...]" can be synonymously or interchangeably used herein with one, two or all of said entity, element and/or step "comprising [...]" and said entity, element and/or step "reflecting [...]". Further, as used herein, phrases such as "based on", "related" or "relating", "associated" and similar are not to be seen exclusively in terms of the entities, elements and/or steps to which they are referring, unless otherwise stated. Instead, these phrases are to be understood inclusively, unless otherwise stated, in that, for example, an entity, element or step referring by any of these phrases or similar, e.g., being "based on", an or another entity, element or step, does not exclude that the respective entity, element or step may be further or also "based on" any other entity, element or step than the one to which it refers.

The designation of methods and steps as first, second, etc. as provided herein is merely intended to make the methods and their steps referenceable and distinguishable from one another. By no means does the designation of methods and steps constitute a limitation of the scope of this disclosure. For example, when this disclosure describes a third step of a method, a first or second step of the method do not need to be present yet alone be performed before the third step unless they are explicitly referred to as being required per se or before the third step. Moreover, the presentation of methods or steps in a certain order is merely intended to facilitate one example of this disclosure and by no means constitutes a limitation of the scope of this disclosure. Generally, unless no explicitly required order is being mentioned, the methods and steps may be carried out in any feasible order. Specifically, the terms first, second, third or (a), (b), (c) and the like in the description and in the claims are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

Any reference signs in the claims should not be construed as limiting the scope.

## Claims

1. A method (100) for obtaining a search result for a search query within a database system (12) of a plant, the database system (13) storing multimodal operating data of the plant, the method (100) comprising:
- obtaining the search query indicative of an operating characteristic in the operating of the plant to be searched within the database system (13);
- executing the search query by an artificial intelligence / machine learning, AI / ML, search component (12) within the database system (13) for finding the searched operating characteristic and time intervals of the operating characteristic among different data modalities of the multimodal data therein; and
- obtaining a search result indicative of the operating characteristic and its time intervals found by the execution of the search query by the AI / ML search component (12).

2. The method (100) of claim 1, wherein the AI / ML search component (12) is a generative AI / ML search component based on at least a Large Language Model, LLM, and/or a multimodal model.

3. The method (100) of claim 1 or 2, wherein the database system (13) contains data representations of the multimodal operating data in a joint embedding space (14).

4. The method (100) of claim 3, wherein the data representations of the multimodal operating data are contextually linked with one another by an information model and/or a knowledge graph.

5. The method (100) of any one of the previous claims, wherein the operating characteristic is an operating parameter of the plant and/or an operating problem of the plant.

6. The method (100) of any one of the previous claims, wherein the search query comprises natural language text, a function, a time series of values, and/or an image indicative of the operating characteristic.

7. The method (100) of any one of the previous claims, wherein the multimodal operating data in the database system (13) is at least from one or more of: time series data, text data, log data, and/or image data.

8. The method (100) of any one of the previous claims, wherein the multimodal operating data in the database system (13) stores one or more of: process variables data, process topology data, analytical model data, operating manual data, event log data, alarm log data, and/or maintenance log data.

9. The method (100) of any one of the previous claims, wherein the search result is configured as a visualization of the found operating characteristic over a timeline including the time intervals.

10. The method (100) of any one of the previous claims, wherein the method (100) further comprises:
- determining a state of the plant for one of the time intervals indicated by the search result, the state being indicative of several operating characteristics of the plant based on the multimodal operating data of the database system (13).

11. The method (100) of claim 10, wherein the method (100) further comprises:
- navigating through the determined state of the plant along a timeline including the time interval on a user interface (11) of a data processing system (10), the several operating characteristics of the state changing while navigating the timeline based on the multimodal operating data of the database system (13).

12. The method (100) of any one of the previous claims, wherein the method (100) further comprises:
- utilizing the search result for analyzing, planning and/or simulating an operation of the plant.

13. The method (100) of any one of the previous claims, wherein the search query is received on a user interface (11) of a data processing system (10) and the search result is provided on the user interface (11).

14. One or more computer program products (18) comprising instructions which, when executed by a data processing system (10), cause the data processing system (10) to carry out the method (100) of any one of the previous claims.

15. A data processing system (10) configured to carry out the method (100) of any one of claims 1 to 13.
